# EUROPÄISCHE PATENTSCHRIFT

(11) **EP 1 361 582 B1**
(45) Veröffentlichungstag und Bekanntmachung des Hinweises auf die Patenterteilung: **05.04.2006**
(21) Anmeldenummer: 03090103.7
(22) Anmeldetag: 10.04.2003
(51) Int. Cl.: G11C 16/22, G11C 7/24, H01H 71/74, H02H 3/00

(54) **Elektronische Speichereinrichtung für Kenngrössen und Umrechnungsfaktoren für elektronische Schutzeinrichtungen von Leistungsschaltern**
Electronic memory for characteristics and factors for an electronic protection circuit of a power switch
Mémoire électronique pour le stockage des caractéristiques et des facteurs d'un circuit électronique de protection d'un disjoncteur

(30) Priorität: 08.05.2002 DE 10221579
(43) Veröffentlichungstag der Anmeldung: 12.11.2003
(73) Patentinhaber: SIEMENS AKTIENGESELLSCHAFT, 80333 München (DE)
(72) Erfinder: Driehorn, Thomas, 12249 Berlin (DE); Krauss, Andreas, 10825 Berlin (DE); Musiol, Aron-Ernst, 12305 Berlin (DE); Pancke, Andreas, 13507 Berlin (DE); Redmann, Ilka, 10555 Berlin (DE); Röhl, Wolfgang, 13503 Berlin (DE)

(56) Entgegenhaltungen:
- DE-A- 10 019 092
- US-A- 4 445 198
- US-A- 4 547 853

## Beschreibung

Die Erfindung betrifft eine elektronische Speichereinrichtung für zur Verarbeitung in einer elektronischen Schutzeinrichtung eines Leistungsschalters vorgesehene Kenngrößen und Umrechnungsfaktoren, wobei die Speichereinrichtung von der Schutzeinrichtung räumlich getrennt im Leistungsschalter angeordnet und mit der Schutzeinrichtung durch Verbindungsleiter verbunden ist, welche Daten und eine von der Schutzeinrichtung bereitgestellte Hilfsenergie zum Betrieb der Speichereinrichtung übertragen.

Den elektronischen Schutzeinrichtungen von Leistungsschaltern werden Messwerte des fließenden Stromes zugeführt, die von den Stromwandlern an den Stromschienen des Schalters erfasst werden. Die Schutzeinrichtung verarbeitet diesen Messwert und vergleicht ihn mit vorgegebenen Kennlinien und ermittelt den Grad der thermischen Belastung oder Auslastung des angeschlossenen Verbrauchers, des Kabels oder des Schalters selbst. Wenn ein bestimmter Strom eine bestimmte Zeit bestanden hat, ist die Wärmekapazität erschöpft und der Strom muss unterbrochen werden. Das ist die Überstrom-Zeitfunktion, die nach bestimmten Kennlinien verläuft. Bei extrem hohen Werten wird das als Kurzschluss betrachtet und nur noch ganz kurze Zeit verzögert, um eine Selektivität zu anderen Schaltern herstellen zu können. Bei noch höheren Werten erfolgt eine sofortige, d. h. unverzögerte Auslösung.

Um eine universelle Verwendbarkeit der Schutzeinrichtung für unterschiedliche Schaltertypen zu ermöglichen, müssen für das Zusammenwirken zwischen den Schutzeinrichtungen und den unterschiedlichen Stromerfassungseinrichtungen Übergabeparameter festgelegt werden, an denen die Schutzeinrichtung erkennen kann, in welchem Schaltertyp, mit welcher Nennstromstärke, er eingebaut ist und mit welchem Faktor seine allgemein gültigen Kennlinien multipliziert werden müssen, um an die real vorliegende Nennstromstärke angepasst zu sein. Für diese Parameterübergabe gibt es verschiedene Systeme. Es gibt zum Beispiel Bemessungsstromstecker (engl. Rating Plug), die an der Bedienungsfront des Schalters eingesteckt werden und die eine Codiereinrichtung enthalten, die den Umrechnungsfaktor festlegt und an die Schutzeinrichtung übermittelt. Damit erkennt der Auslöser die Nennstromstärke des Schalters, in dem er eingesetzt ist und mit welchem Faktor seine Kennlinien multipliziert werden müssen. Ein solcher Bemessungsstromstecker kann einen elektronischen Speicher enthalten, der beschreibbar und auslesbar ist und alle von der Schutzeinrichtung benötigten Informationen enthalten kann.

Eine Speichereinrichtung mit gleichen Funktionen kann auch an einer anderen Stelle in einem Leistungsschalter eingebaut sein, und zwar insbesondere im Zuge eines Kabelbaumes, der sich zwischen Stromerfassungseinrichtungen und der Schutzeinrichtung erstreckt. Eine solche Anordnung (Schalterkennmodul) ist der DE 100 19 092 A1 zu entnehmen. Die in bekannter Weise als elektronischer Überstromauslöser ausgebildete Schutzeinrichtung befindet sich dabei in einem vorderen Bereich des Leistungsschalters hinter einem Bedienpult. Dagegen sind Stromwandler bzw. Stromsensoren, die Messwerte des Stromes in jedem der Pole des Leistungsschalters erfassen und eine zum Betrieb der Schutzeinrichtung benötigte Hilfsenergie bereitstellen, an der dem Bedienpult gegenüberliegenden Rückseite des Leistungsschalters angeordnet. Ein Kabelbaum verbindet diese beiden Bereiche des Leistungsschalters. Der zur Speicherung von der Baugröße und Ausstattung des Leistungsschalters abhängiger Kenngrößen und Umrechnungsfaktoren dienende elektronische Speichereinrichtung ist im Zuge dieses Kabelbaumes angeordnet.

Ein Kabelbaum oder sonstige Verbindungsleitungen für den genannten Zweck sind magnetischen, elektrischen und elektromagnetischen Felder ausgesetzt, die im Betrieb eines Leistungsschalters auftreten. Durch geeignete Abschirmungen (US 5,303,113) kann dafür gesorgt werden, dass diese Felder den Betrieb der elektronischen Speichereinrichtung nicht stören. Da aber die störenden Feldeinflüsse in einem Leistungsschalter statistischen Gesetzmäßigkeiten unterliegen und von der Höhe des Stromes im Leistungsschalter abhängen, kann dennoch nicht völlig ausgeschlossen werden, dass es zu einer Beeinflussung der elektronischen Speichereinrichtung kommt. An sich könnte eine einfache Lösung dieses Problems darin gesehen werden, dass ein Schreibschutzsystem aktiviert wird, mit dem übliche elektronische Speicher ausgestattet sind. Dieses System verhindert nämlich, dass ungewollt Daten in die Speichereinrichtung geschrieben oder vorhandene Daten überschrieben werden. Die Benutzung des Schreibschutzsystems setzt voraus, dass ein hierfür vorgesehener Anschlusspunkt der Speichereinrichtung mit einem positiven Potential beaufschlagt wird (US 5 363 334). Befindet sich der betreffende Anschlusspunkt dagegen auf dem Potential der Schaltungsmasse, so sind Schreib- und Leseoperationen unbeschränkt möglich.

Dem zwanglosen Einsatz des Schreibschutzsystems bei Leistungsschaltern der erläuterten Art steht entgegen, dass infolge der räumlichen Trennung der Schutzeinrichtung und der Speichereinrichtung ein zusätzlicher Verbindungsleiter für den Schreibschutz benötigt wird. Dieser steht aber aus unterschiedlichen Gründen nicht zur Verfügung, insbesondere weil ein standardisierter Kabelbaum weiterhin benutzt werden soll oder weil beschränkte Durchlassquerschnitte im Gehäuse des Leistungsschalters die verlegung eines weiteren Verbindungsleiters nicht erlauben.

Die Aufgabe der vorliegenden Erfindung besteht davon ausgehend darin, mit einer aufgrund gegebener Bauelemente (Leitungsbündel, Kabelbäume o.ä.) beschränkten Anzahl von Verbindungsleitungen zusätzlich zu den bisherigen Schreib- und Leseoperationen auch das Schreibschutzsystem der Speichereinrichtung zu steuern.

Diese Aufgabe wird gemäß der Erfindung dadurch gelöst, dass die Umschaltung der Speichereinrichtung von dem schreibgeschützten in den beschreibbaren Zustand durch eine Änderung der Polarität der die Hilfsenergie übertragenden Verbindungsleiter und eine entsprechende Veränderung des Spannungspegels an einem Schreibschutzeingang eines zu der Speichereinrichtung gehörenden elektronischen Speichers erfolgt und dass die Speichereinrichtung eine Gleichrichteranordnung zur Aufrechterhaltung der Polarität der Hilfsenergie für den Betrieb des Speichers enthält.

Im Rahmen der Erfindung kann die Speichereinrichtung als elektronischen Speicher ein I²C-EEPROM aufweisen, wobei die Gleichrichteranordnung als Brückenschaltung ausgebildet ist, deren Wechselstromseite mit den Verbindungsleitern für die Hilfsenergie und deren Gleichstromseite mit den Versorgungsanschlüssen des I²C-EEPROMs verbunden ist und der Schreibschutzanschluss des I²C-EEPROMs über eine Diode mit der einen Verbindungsleitung für die Hilfsenergie und mittels eines Widerstandes mit dem die Schaltungsmasse bereitstellenden Anschlusspunkt der Gleichrichteranordnung verbunden ist.

Für die Erfindung ist der Ort der Unterbringung des elektronischen Speichereinrichtung im Leistungsschalter ist völlig sekundär. Daher ist die Erfindung für beliebige außerhalb der Schutzeinrichtung befindliche Speichereinrichtungen anwendbar, insbesondere wenn diese als Bemessungsstromstecker ausgebildet sind und deren Eingang als Steckkontakt ausgeführt ist. Gleichfalls ist die Erfindung vorteilhaft anwendbar bei einer Speichereinrichtung, die in einem zur Verbindung einer Stromerfassungseinrichtung mit der Schutzeinrichtung des Leistungsschalters vorgesehenen, die Verbindungsleiter aufweisenden Kabelbaum angeordnet und in diesen integriert ist.

Die Erfindung soll zum besseren Verständnis nachfolgend anhand eines bevorzugten, den Schutzumfang nicht einschränkenden Ausführungsbeispiels näher erläutert werden.

Die Fig. 1 zeigt schematisch den prinzipiellen Aufbau eines Niederspannungs-Leistungsschalters im Schnitt.

Die Fig. 2 zeigt einen erfindungsgemäßen elektronischen Speicher für Kenngrößen und Umrechnungsfaktoren für elektronische Schutzeinrichtungen von Leistungsschaltern, für eine erfindungsgemäße Speichereinrichtung, welcher von der Schutzeinrichtung räumlich getrennt im Leistungsschalter untergebracht sein kann und einen von der Schutzeinrichtung les- und beschreibbaren elektronischen Speicherbaustein für betriebliche Daten des Leistungsschalters enthält, im schreibgeschützten Zustand.

Die Fig. 3 zeigt den gleichen elektronischen Speicher für Kenngrößen und Umrechnungsfaktoren für elektronische Schutzeinrichtungen von Leistungsschaltern, im programmierbaren Zustand.

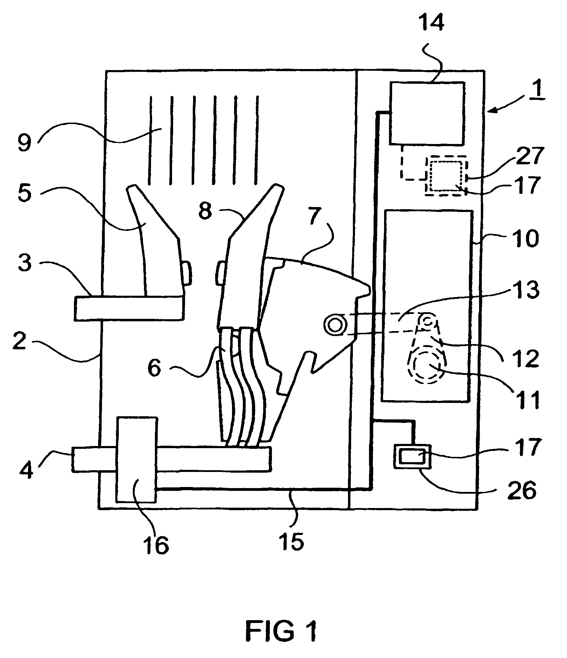

In der Fig. 1 ist schematisch der prinzipielle Aufbau eines Niederspannungs-Leistungsschalters 1 im Schnitt dargestellt. Durch die Rückwand 2 des Niederspannungs-Leistungsschalters 1 sind die obere Anschlussschiene 3 und die untere Anschlussschiene 4 hindurchgeführt. An der oberen Anschlussschiene 3 befindet sich der feste Schaltkontakt 5 und an der unteren Anschlussschiene 4 ist über flexible Verbindungen 6 der auf einem Kontaktträger 7 befindliche bewegbare Schaltkontakt 8 angeschlossen. Über dem festen Schaltkontakt 5 und dem bewegbaren Schaltkontakt 8 ist die Lichtbogenlöschkammer 9 angeordnet. Im Schalterantrieb 10 befindet sich eine Schaltwelle 11 mit einem Schaltwellenausleger 12, welcher zusammen mit einer Koppellasche 13 die Verbindung der Schaltwelle 11 zum Kontaktträger 7 bildet. An der Bedienungsseite des Leistungsschalters 1 befindet sich eine elektronische Schutzeinrichtung 14, welche über einen Kabelbaum 15 mit einer Stromerfassungseinrichtung 16 auf der unteren Anschlussschiene 4 des Niederspannungs-Leistungsschalters 1 verbunden ist. Unter Stromerfassungseinrichtungen werden in diesem Zusammenhang induktive Stromwandler oder Stromsensoren anderer Art, z. B. Rogowski-Stromwandler, verstanden. Die elektronische Schutzeinrichtung 14 kann insbesondere ein elektronischer Überstromauslöser sein. In dem Kabelbaum 15 ist in dieser Ausführungsvariante eine elektronische Speichereinrichtung 17 integriert, die einen Schalterkennmodul 26 bildet.

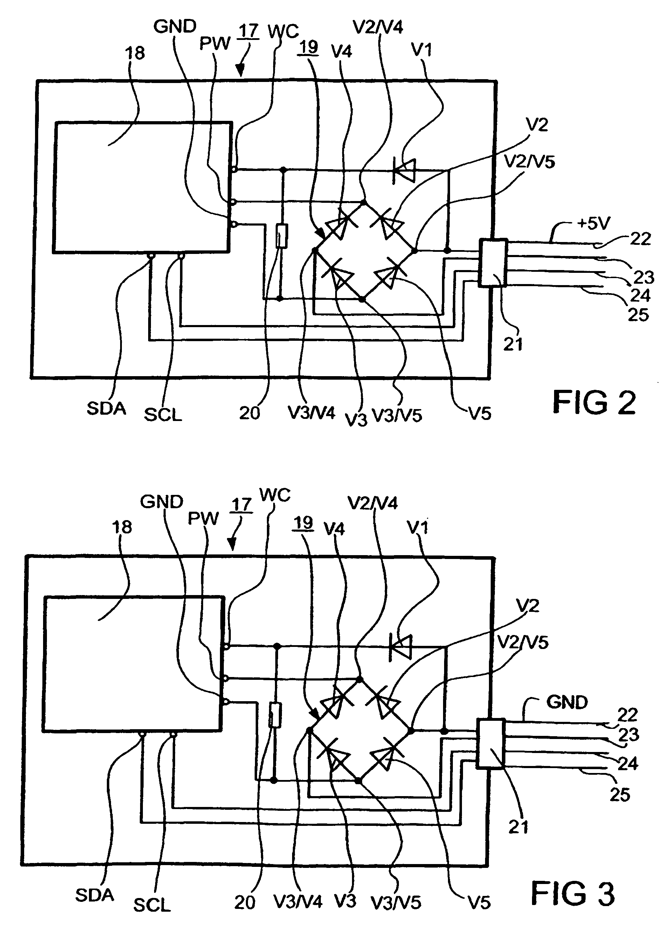

Die Fig. 2 zeigt die elektronische Speichereinrichtung 17 für Kenngrößen und Umrechnungsfaktoren für die elektronische Schutzeinrichtung 14 im schreibgeschützten Zustand.

Die elektronische Speichereinrichtung 17 enthält als elektronischen Speicher einen Speicher 18, der als I²C-EEPROM ausgebildet ist, eine aus den Dioden V2, V3, V4 und V5 bestehende Gleichrichteranordnung 19 in der Gestalt einer bekannten Brückenschaltung, eine Diode V1, einen Widerstand 20 und einen vierpoligen Eingang 21.

Eine erste Verbindungsleitung 22 des vierpoligen Eingangs 21 ist nach außen mit einer +5V-Stromversorgung der elektronischen Schutzeinrichtung 14 des Leistungsschalters 1 verbunden und im Innern der Speichereinrichtung 17 mit einem Wechselspannungs-Anschlusspunkt V2/V5 der Gleichrichter-Brückenschaltung 19 sowie mit der Gleichrichterdiode V1, die in der Durchlassrichtung mit einem Schreibschutzeingang WC des Speichers 18 (I²C-EEPROM) verbunden ist. Eine zweite Verbindungsleitung 23 des vierpoligen Eingangs 21 ist nach außen mit der Schaltungsmasse der Schutzeinrichtung 14 verbunden und im Innern der Speichereinrichtung 17 mit dem anderen Wechselspannungs-Anschlusspunkt V3/V4 der Gleichrichteranordnung 19. Über eine dritte Verbindungsleitung 24 des vierpoligen Eingangs 21 ist der Anschluss SCL des Speichers 18 für den Takt und durch eine vierte Verbindungsleitung 25 ein Dateneingang SDA mit der Schutzeinrichtung verbunden. Die Gleichspannungs-Anschlusspunkte V2/V4 und V3/V5 der Gleichrichteranordnung 19 sind mit den Anschlüssen PW (positives Potential 5V)und GND (Schaltungsmasse, 0V) des Speichers 18 verbunden.

Die Anzahl der Verbindungsleiter 22, 23, 24, 25, die in dem Kabelbaum 15 zusammengefasst sind, ist auf die genannte Anzahl von vier beschränkt. Somit steht kein gesonderter Verbindungsleiter zur Verfügung, über welchen der Schreibschutzeingang WC des Speichers 18 (I²C-EEPROM) beeinflusst werden könnte. Durch die Gleichrichteranordnung 19 wird jedoch dafür gesorgt, dass dennoch eine gewünschte Steuerung des Schreibschutzeinganges WC möglich ist. Hierzu ist der Masseanschluss GND des Speichers 18 ist mit dem negativen Gleichspannungs-Anschlusspunkt V3/V5 der Gleichrichteranordnung 19 verbunden und über einen Widerstand 20 mit dem Schreibschutzeingang WC des Speichers 18. An den positiven Gleichspannungs-Anschlusspunkt V2/V4 der Gleichrichteranordnung 19 ist die +5V-Stromversorgung PW des Speichers 18 angeschlossen.

Bei der vorliegenden Anschlussbeschaltung ist die Polarität der Hilfsenergie für den Betrieb des Speichers 18 an den Anschlüssen GND und PW unabhängig von der Polarität der Verbindungsleitungen 22 und 23. Durch eine Umkehrung der Polarität der betreffenden Verbindungsleitungen im Kabelbaum 15 mittels der Schutzeinrichtung 14 oder auf andere Weise, die somit ohne Einfluss auf den Betrieb des elektronischen Speichers 18 bleibt, wird nun dafür gesorgt, dass wahlweise die Schreibschutzeinrichtung des Speichers 18 aktiviert oder deaktiviert wird.

Zum Verständnis dieser Schaltung wird zunächst die Figur 2 betrachtet, die den Zustand bei aktiviertem Schreibschutz darstellt. Wesentlich ist hierbei die Beaufschlagung der Verbindungsleitung 22 mit positivem Potential (5V), während die Verbindungsleitung 23 auf Schaltungsmasse (GND) gelegt ist. Das positive Potential an 22 gelangt über die Diode V1 an den Schreibschutzeingang WC des Speichers 18 und bewirkt in bekannter Weise, dass keine Daten in den Speicher eingeschrieben und somit schon vorhandene Daten weder überschrieben noch verändert oder gelöscht werden können. In den Kabelbaum bzw. die Verbindungsleitungen 22, 23, 24, und 25 eingekoppelte Störungen bleiben somit ohne Folgen. In diesem Zustand können nur die im Speicher 18 vorhandenen Daten auf Anforderung der Schutzeinrichtung 14 über die Verbindungsleitungen 24 und 25 ausgelesen und in bekannter Weise verarbeitet werden.

Die Fig. 3 zeigt die gleiche erfindungsgemäße les- und beschreibbaren elektronische Speichereinrichtung 17 für betriebliche Daten des Leistungsschalters 1 in dem Zustand, dass sie durch die Schutzeinrichtung 14 oder auf andere Weise (z. B. bei der Fertigung des Kabelbaumes 15 mit integriertem Schalterkennmodul 25) beschrieben werden kann.

Die Freigabe des Speichers 18 in der Speichereinrichtung 17 zum Beschreiben erfolgt durch Umkehrung der Polarität der Verbindungsleitungen 22 und 23, in der Weise, dass nun die Verbindungsleitung 22 an Schaltungsmasse (GND) gelegt ist und die Verbindungsleitung 23 auf positives Potential (+5V). Der Schreibschutzeingang WC des Speichers 18 gelangt nun über den Widerstand 20 auf Schaltungsmasse (GND). In diesem Zustand kann der Speicher 18 programmiert, d.h. mit zusätzlichen oder neuen Daten versehen werden. Obwohl die Änderung der Daten im Speicher 18 mittels der Schutzeinrichtung 14 erfolgen könnte, wenn diese hierzu über einen besonderen Programmiermodus verfügt, kann diese Möglichkeit dadurch bewusst ausgeschlossen werden, dass die Polarität der Verbindungsleitungen 22 und 23 beim Anschluss des Kabelbaumes 15 an die Schutzeinrichtung 14 festgelegt ist. Damit besteht ständig Schreibschutz. Eine Programmierung der Speichereinrichtung 17 ist dann nur bei der Fertigung des Kabelbaumes mit integriertem Schalterkennmodul 26 oder dadurch möglich, dass die Schutzeinrichtung 14 aus dem Leistungsschalter 1 entfernt und mit der dabei frei werdenden Anschlussvorrichtung des Kabelbaumes 15 ein Programmiergerät verbunden wird, das die Deaktivierung des Schreibschutzes ermöglicht.

Die erfindungsgemäße Lösung erhöht den Schutz vor Überschreiben des Speichers 18 (I²C-EEPROM) erheblich. Hierfür ist keine zusätzliche Leitung erforderlich. Es kann somit mittels eines standardmäßig vorgesehenen Kabelbaumes, der auf vier Verbindungsleitungen zwischen der Schutzeinrichtung 14 und der Speichereinrichtung 17 beschränkt ist, die Schreibschutzeinrichtung benutzt werden, obwohl der Speicher selbst durch seinen Einbau im Leistungsschalter unzugänglich ist.

Wird die Speichereinrichtung 17 im Unterschied zu dem beschriebenen Ausführungsbeispiel in der Gestalt eines Bemessungsstromsteckers 27 verwendet, wie dies in der Figur 1 gestrichelt gezeigt ist, so ist sie im Prinzip den gleichen Störeinflüssen ausgesetzt wie der in den Kabelbaum 15 integrierte Modul 25. Zweckmäßig wird die Polarität der Versorgungsleitungen am Eingang 21 seitens der Schutzeinrichtung 14 so gewählt, dass ständig Schreibschutz besteht. Eine Freigabe des Speichers 18 zum Beschreiben bzw. Programmieren kann dann erst erfolgen, wenn der Bemessungsstromstecker 27 aus dem Leistungsschalter 1 entnommen und in eine Programmiereinrichtung eingebracht wird, die eine umgekehrte Polarität an den Wechselstromanschlusspunkten V2/V5 und V3/V4 der Gleichrichterschaltung 19 bewirkt.

## Patentansprüche

1. Leistungsschalter (1) mit einer elektronischen Speichereinrichtung (17) für zur Verarbeitung in einer elektronischen Schutzeinrichtung (14) des Leistungsschalters (1) vorgesehene Kenngrößen und Umrechnungsfaktoren, wobei die Speichereinrichtung (17) von der Schutzeinrichtung (14) räumlich getrennt im Leistungsschalter (1) angeordnet und mit der Schutzeinrichtung (14) durch Verbindungsleiter (22, 23, 24, 25) verbunden ist, welche Daten und eine von der Schutzeinrichtung (14) bereitgestellte Hilfsenergie zum Betrieb der Speichereinrichtung (17) übertragen,
**dadurch gekennzeichnet,**
**dass** die Umschaltung der Speichereinrichtung (17) von einem schreibgeschützten in einen beschreibbaren Zustand durch eine Änderung der Polarität der die Hilfsenergie übertragenden Verbindungsleiter (22, 23) und eine entsprechende Veränderung des Spannungspegels an einem Schreibschutzeingang (WC) des zu der Speichereinrichtung (17) gehörenden elektronischen Speichers (18) erfolgt und dass die Speichereinrichtung (17) eine Gleichrichteranordnung (19) zur Aufrechterhaltung der Polarität der Hilfsenergie für den Betrieb des Speichers (18) enthält.

2. Leistungsschalter (1) nach Anspruch 1,
**dadurch gekennzeichnet,**
**dass** die Speichereinrichtung (17) als elektronischen Speicher (18) ein I²C-EEPROM aufweist, dass die Gleichrichteranordnung (19) als Brückenschaltung ausgebildet ist, deren Wechselstromseite (V2/V5, V3/V4) mit den Verbindungsleitern (22, 23) für die Hilfsenergie und deren Gleichstromseite (V2/V4, V3/V5) mit den Versorgungsanschlüssen (PW, GND) des Speichers (18) verbunden ist und dass der Schreibschutzanschluss (WC) des Speichers (18) über eine Diode (V1) mit der einen Verbindungsleitung (22) für die Hilfsenergie und mittels eines Widerstandes (20) mit dem die Schaltungsmasse (GND) bereitstellenden Anschlusspunkt (V3/V5) der Gleichrichteranordnung (19) verbunden ist.

3. Leistungsschalter nach Anspruch 1,
**dadurch gekennzeichnet,**
**dass** die Speichereinrichtung (17) als Bemessungsstromstecker (27) ausgebildet und der Eingang (21) der Speichereinrichtung (17) zum Anschluss der Verbindungsleiter (22, 23, 24, 25) als Steckkontakt ausgeführt ist.

4. Leistungsschalter nach Anspruch 1,
**dadurch gekennzeichnet,**
**dass** die Speichereinrichtung (17) als Schalterkennmodul (26) in einem Kabelbaum (15) angeordnet und in diesen integriert ist, wobei der Kabelbaum (15) eine Stromerfassungseinrichtung (16) mit der Schutzeinrichtung (14) des Leistungsschalters (1) verbindet und der Kabelbaum die Verbindungsleiter (22, 23, 24, 25) aufweist.

## Revendications

1. Disjoncteur (1) ayant un dispositif (17) électronique de mémoire pour des grandeurs caractéristiques et des facteurs de conversion destinés à être traités dans un dispositif (14) électronique de protection du disjoncteur (1), le dispositif (17) de mémoire étant disposé dans le disjoncteur (1) en étant séparé dans l'espace du dispositif (14) de protection et étant relié au dispositif (14) de protection par des conducteurs (22, 23, 24, 25) de liaison qui transmettent, pour faire fonctionner le dispositif (17) de mémoire, des données et une énergie auxiliaire procurée par le dispositif (14) de protection,
**caractérisé**
**en ce que** la commutation du dispositif (17) de mémoire d'un état protégé en écriture à un état permettant d'écrire s'effectue par une modification de la polarité des lignes (22, 23) de liaison transmettant l'énergie auxiliaire et par une modification correspondante du niveau de tension sur une entrée (WC) de protection en écriture de la mémoire (18) électronique appartenant au dispositif (17) de mémoire, et en ce que le dispositif (17) de mémoire comporte un dispositif (19) redresseur pour maintenir la polarité de l'énergie auxiliaire pour le fonctionnement de la mémoire (18).

2. Disjoncteur (1) suivant la revendication 1,
**caractérisé**
**en ce que** le dispositif (17) de mémoire comporte comme mémoire (18) électronique une I²C-EEPROM, en ce que le dispositif (19) redresseur est constitué sous la forme d'un circuit en pont dont le côté (V2/V5, V3/V4) de courant alternatif est relié aux conducteurs (22, 23) de liaison pour l'énergie auxiliaire et dont le côté (V2/V4, V3/V5) de courant continu est relié aux bornes (PW, GND) d'alimentation de la mémoire (18), et en ce que la borne (WC) de protection en écriture de la mémoire (18) est reliée par une diode (V1) à l'une des lignes (22) de liaison pour l'énergie auxiliaire et au moyen d'une résistance (20) au point (V3/V5) du dispositif (19) redresseur de connexion procurant la masse (GND) du circuit.

3. Disjoncteur suivant la revendication 1,
**caractérisé**
**en ce que** le dispositif (17) de mémoire est constitué en prise (27) de courant nominal et l'entrée (21) du dispositif (17) de mémoire est réalisée pour la connexion des conducteurs (22, 23, 24, 25) de liaison sous la forme d'un contact à enfichage.

4. Disjoncteur suivant la revendication 1,
**caractérisé**
**en ce que** le dispositif (17) de mémoire est disposé sous la forme d'un module (26) de reconnaissance de coupure dans un faisceau (15) de câbles et y est intégré le faisceau (15) de câbles reliant un dispositif (16) de détection du courant au dispositif (14) de protection du disjoncteur (1) et le faisceau de câbles ayant les conducteurs (22, 23, 24, 25) de liaison.

## Claims

1. Circuit breaker (1) having an electronic memory device (17) for characteristics and conversion factors which are provided for processing purposes in an electronic protection device (14) of the circuit breaker (1), the memory device (17) being arranged in the circuit breaker (1) such that it is physically separated from the protection device (14) and being connected to the protection device (14) by means of connecting conductors (22, 23, 24, 25) which transmit data and auxiliary power, which is provided by the protection device (14), for the operation of the memory device (17), **characterized in that** the memory device (17) is switched over from a write-protected state to a writable state by means of a change in the polarity of the connecting conductors (22, 23) transmitting the auxiliary power and a corresponding change in the voltage level at a write protection input (WC) of the electronic memory (18) associated with the memory device (17), and **in that** the memory device (17) contains a rectifier arrangement (19) for the purpose of maintaining the polarity of the auxiliary power for the operation of the memory (18).

2. Circuit breaker (1) according to Claim 1, **characterized in that** the memory device (17) has an I²C EEPROM as the electronic memory (18), **in that** the rectifier arrangement (19) is in the form of a bridge circuit, whose AC side (V2/V5, V3/V4) is connected to the connecting conductors (22, 23) for the auxiliary power, and whose DC side (V2/V4, V3/V5) is connected to the supply connections (PW, GND) of the memory (18), and **in that** the write protection connection (WC) of the memory (18) is connected to one connecting line (22) for the auxiliary power via a diode (V1) and to the connection point (V3/V5) of the rectifier arrangement (19) providing the circuit earth (GND) by means of a resistor (20).

3. Circuit breaker according to Claim 1, **characterized in that** the memory device (17) is in the form of a rating plug (27), and the input (21) of the memory device (17) for connecting the connecting conductors (22, 23, 24, 25) is in the form of a plugging contact.

4. Circuit breaker according to Claim 1, **characterized in that** the memory device (17) is arranged in a cable harness (15) as a switch identification module (26) and is integrated in said cable harness (15), the cable harness (15) connecting a current detection device (16) to the protection device (14) of the circuit breaker (1), and the cable harness having the connecting conductors (22, 23, 24, 25).
